Europäisches Patentamt

European Patent Office

Office européen des brevets

(11) Numéro de publication: **0 632 624 A1**

# DEMANDE DE BREVET EUROPEEN

(21) Numéro de dépôt: **94201788.0**

(22) Date de dépôt: **22.06.94**

(51) Int. Cl.⁶: **H04L 27/36**, H03F 1/32, H04L 5/06

(30) Priorité: **29.06.93 FR 9307922**

(43) Date de publication de la demande:
**04.01.95 Bulletin 95/01**

(84) Etats contractants désignés:
**DE FR GB IT**

(71) Demandeur: **LABORATOIRES D'ELECTRONIOUE PHILIPS
22, Avenue Descartes
F-94450 Limeil-Brévannes (FR)**
(84) **FR**

(71) Demandeur: **PHILIPS ELECTRONICS N.V.
Groenewoudseweg 1
NL-5621 BA Eindhoven (NL)**

(84) **DE GB IT**

(72) Inventeur: **Brajal, Américo
Société Civile S.P.I.D.,
156, Boulevard Haussmann
F-75008 Paris (FR)**
Inventeur: **Chouly, Antoine
Société Civile S.P.I.D.,
156, Boulevard Haussmann
F-75008 Paris (FR)**

(74) Mandataire: **Landousy, Christian et al
Société Civile S.P.I.D.
156, Boulevard Haussmann
F-75008 Paris (FR)**

(54) **Système de transmission numérique à prédistorsion.**

(57) Système de transmission de signaux numériques opérant par codage d'une constellation, le système comprenant une unité (10) de modulation par répartition multiplexée de fréquences orthogonales dite modulation OFDM, qui génère des signaux OFDM (S1) et un amplificateur (12) qui provoque des distorsions de signaux. Le système comprend un circuit de prédistorsion (20) placé entre l'unité de modulation OFDM et l'amplificateur, ledit circuit pré-distordant les signaux OFDM (S1), reçus en entrée, dans un sens opposé aux distorsions créées par l'amplificateur et générant des signaux OFDM pré-distordus (S2) tels qu'après leur passage dans l'amplificateur celui-ci délivre des signaux OFDM (S3) non distordus.

Le système peut opérer en mode fixe ou en mode adaptatif.

Application : transmissions numériques.

FIG.12

L'invention concerne un système de transmission de signaux numériques opérant par codage d'une constellation, le système comprenant une unité de modulation à multiporteuses qui génère des signaux à multiporteuses et un amplificateur qui provoque des distorsions de signaux.

Le système de transmission numérique peut être utilisé pour la transmission de signaux de télévision numérique (audio et/ou vidéo) vers des récepteurs portables, des récepteurs mobiles ou autres.

On connaît le document : "Principles of modulation and channel coding for digital broadcasting for mobile receivers" de M. ALLARD et R. LASALLE, EBU Review - Technical, n° 224, Août 1987, Bruxelles (Belgique). Ce document décrit la technique de modulation par répartition multiplexée de fréquences orthogonales qui consiste à multiplexer en fréquence plusieurs porteuses orthogonales modulées par exemple par des symboles issus d'une constellation. Une telle technique dispose d'une très grande robustesse vis-à-vis des évanouissements du signal reçu en cas de modification du canal de transmission.

La technique de modulation à multiporteuses, par exemple de modulation par répartition multiplexée de fréquences orthogonales sera par la suite identifiée par l'appellation simplifiée OFDM qui en langue anglaise signifie Orthogonal Frequency Division Multiplexing.

Lorsque les signaux OFDM ont été formés, ils doivent être émis dans un canal et pour cela ils doivent être amplifiés par un amplificateur de puissance. Un point particulièrement critique en faisceaux hertziens et en transmission soit par satellite soit par voie terrestre est la non-linéarité de l'amplificateur de puissance d'émission ou de l'amplificateur de puissance embarqué dans le cas des transmissions par satellite. Ces amplificateurs sont connus pour leurs caractéristiques non-linéaires. Si on les utilise dans leur zone linéaire on ne bénéficie pas totalement de leur puissance. Si on les fait fonctionner proche de leur puissance de saturation, ils distordent le signal d'une façon inacceptable. En pratique, étant donné un amplificateur de puissance, on fixe le niveau du signal émis de façon à établir un compromis entre le rapport signal à bruit et la distorsion non-linéaire subie par le signal. Ainsi le point de fonctionnement optimal de l'amplificateur est celui minimisant les effets conjoints du bruit additif du canal et de la distorsion non-linéaire de l'amplificateur. Pour des modulations à grand nombre d'états ce point est loin de la puissance de saturation de l'amplificateur, ce qui signifie que celui-ci n'est pas utilisé d'une façon efficace. Dans le cas d'un système à monoporteuse, pour augmenter son efficacité, on utilise couramment des techniques de prédistorsion (fixe ou adaptative) qui permettent de réduire l'effet de la non-linéarité de l'amplificateur de puissance sur le signal émis.

Dans le cas d'un système à monoporteuse, une technique connue consiste à modifier l'alphabet des données à émettre. Cette technique appelée "prédistorsion de données" ou "prédistorsion en bande de base" est connue de l'article de A.A.M. SALEH et J. SALZ "Adaptive linearization of power amplifiers in digital radio systems" Bell System Technical Journal, vol. 62, Avril 1983, pages 1019-1033. Dans le cas de modulations à grand nombre d'états, par exemple une modulation d'amplitude à deux porteuses en quadrature, (MAQ 64, MAQ 256), l'amplificateur agit sur la constellation en produisant une nette compression et une nette rotation des points de grande amplitude. Pour compenser cet effet, la constellation d'origine est distordue de telle sorte qu'elle reprend sa forme carrée originelle après son passage dans l'amplificateur de puissance.

Une telle technique de prédistorsion opérant sur un système à monoporteuse ne peut pas être appliquée à un système à multiporteuses. En effet, avec un système à monoporteuse la prédistorsion est effectuée sur les symboles de la constellation. Si on applique la même technique à chacune des porteuses d'un système OFDM, il apparaît en sortie de l'amplificateur des distorsions dues à des interférences interporteuses qui ne peuvent pas être corrigées. Ces interférences interporteuses sont créées entre les symboles émis par d'autres porteuses. D'autre part, un système à multiporteuses est beaucoup plus sensible qu'un système à monoporteuse aux non linéarités de l'amplificateur à cause des amplitudes crêtes beaucoup plus importantes pour les signaux OFDM que pour les signaux monoporteuses.

Le but de l'invention est donc de réaliser un dispositif qui permette d'effectuer une prédistorsion spécifique à un système à multiporteuses en évitant les inconvénients énoncés précédemment.

Ce but est atteint avec un système qui comprend un un circuit de prédistorsion placé entre l'unité de modulation à multiporteuses et l'amplificateur, ledit circuit prédistordant les signaux à multiporteuses, reçus en entrée, dans un sens opposé aux distorsions créées par l'amplificateur et générant des signaux prédistordus à multiporteuses tels qu'après leur passage dans l'amplificateur celui-ci délivre des signaux non distordus à multiporteuses.

Ainsi on distord non pas les symboles issus de la constellation mais les signaux OFDM comprenant la totalité des porteuses modulées. Ceci présente l'avantage de supprimer les distorsions dues aux interférences entre porteuses modulées.

Préférentiellement le circuit de prédistorsion prédistord l'amplitude et la phase des signaux d'entrée en fonction de leur amplitude.

Plus particulièrement le circuit de prédistorsion comprend :

- des moyens pour échantillonner et quantifier les signaux d'entrée,
- des moyens pour prédistordre des valeurs d'amplitude polaire et de phase des signaux d'entrée,
- des moyens pour générer des composantes en phase et en quadrature des signaux prédistordus.

Le circuit de prédistorsion peut comprendre en entrée une unité de conversion cartésienne/polaire pour convertir les signaux d'entrée échantillonnés.

Le circuit de prédistorsion peut également comprendre un circuit d'adaptation qui calcule des écarts entre les signaux d'entrée du circuit et les signaux de sortie de l'amplificateur et qui adapte les moyens de prédistorsion pour réduire ces écarts. Le système peut ainsi s'adapter aux fluctuations de l'amplificateur dues notamment aux variations de température, au vieillissement ou autres.

Ces différents aspects de l'invention et d'autres encore seront apparents et élucidés à partir des modes de réalisation décrits ci-après.

L'invention sera mieux comprise à l'aide des figures suivantes données à titre d'exemples non limitatifs qui représentent :

Figure 1 : un schéma d'un émetteur (A) et d'un récepteur (B) connus de transmission numérique.

Figure 2 : deux courbes indiquant la distorsion d'amplitude et la distorsion de phase engendrées par l'amplificateur de sortie.

Figure 3 : un schéma d'une unité de modulation OFDM et un schéma d'une unité de démodulation OFDM.

Figure 4 : un schéma d'un multiplexeur OFDM.

Figure 5 : un schéma d'un démultiplexeur OFDM.

Figure 6 : deux représentations de la distribution du signal OFDM en sortie du modulateur OFDM et en sortie de l'amplificateur.

Figure 7 : une représentation d'une constellation MAQ 16 en sortie de la démodulation, sans le circuit de prédistorsion de l'invention.

Figure 8 : un histogramme de la partie réelle des signaux reçus à la sortie de la démodulation.

Figure 9 : un circuit de prédistorsion selon l'invention inséré entre une unité de modulation et l'amplificateur.

Figure 10 : deux représentations d'une partie annulaire de la tache à la sortie de l'amplificateur et dans cette partie annulaire on a représenté un point de la tache avant prédistorsion et le même point après prédistorsion.

Figure 11 : un schéma d'un circuit de prédistorsion fixe selon l'invention.

Figure 12 : un schéma d'un circuit de prédistorsion adaptative selon l'invention.

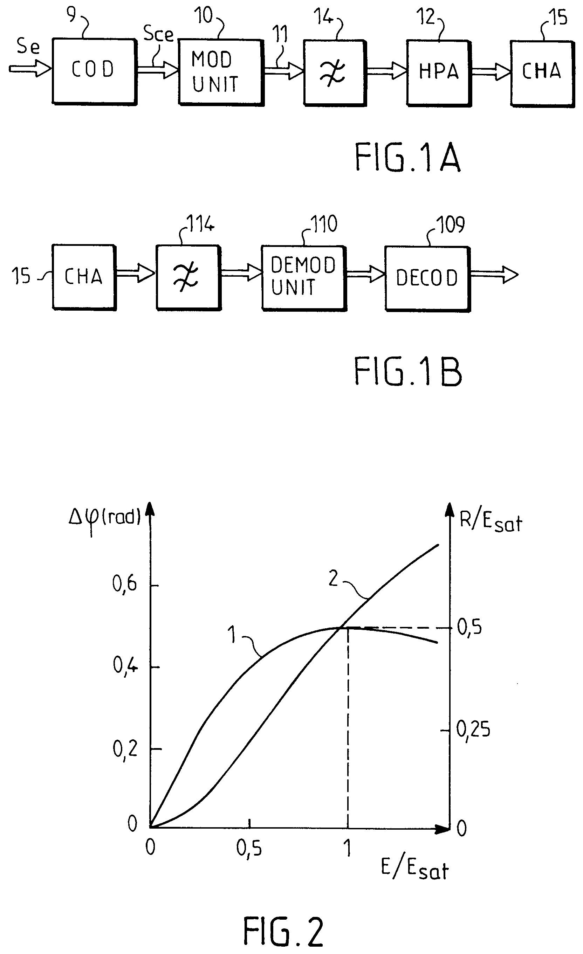

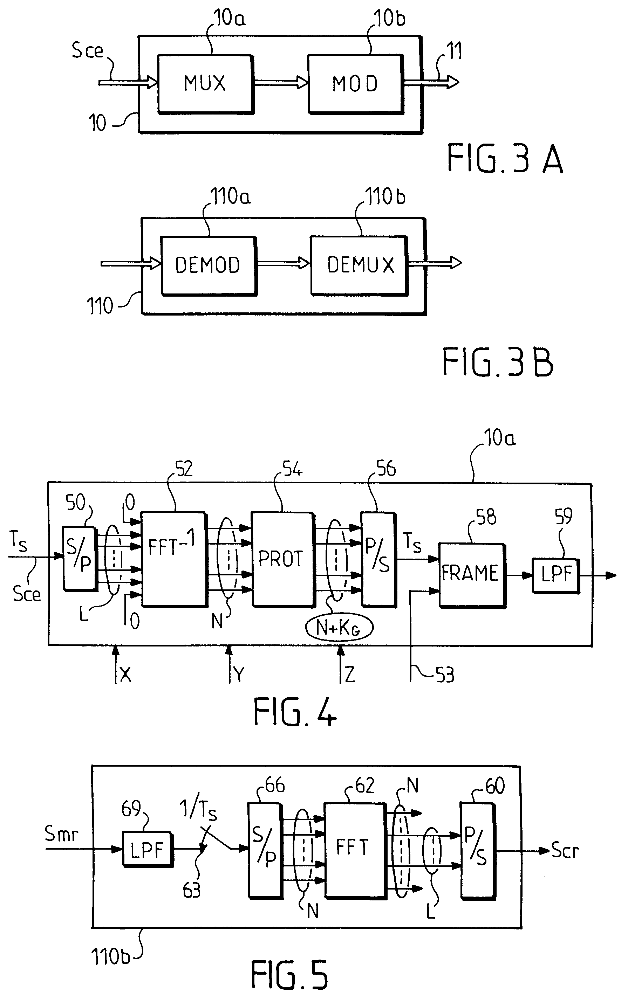

La figure 1 représente une chaîne de traitement d'un système de transmission numérique. A l'émission (figure 1-A), elle comprend en série : des moyens de codage 9 de symboles Se à émettre, une unité de modulation 10, un filtre passe-bas 14 et un amplificateur de puissance 12. Un canal de transmission CHA 15 transmet des signaux issus de la chaîne d'émission. Dans le cas d'une modulation OFDM (figure 3-A), les symboles $S_{ce}$ issus du codage sont multiplexés par un multiplexeur 10a puis servent à moduler des porteuses dans un modulateur 10b. Les signaux OFDM ainsi obtenus (connexion 11) sont amplifiés, après filtrage, par l'amplificateur 12 pour fournir des signaux OFDM à émettre (figure 1-A).

A la réception (figure 1-B), le système comprend un filtre 114, une unité de démodulation DEMOD 110 suivi d'un décodeur DECOD 109. L'unité de démodulation 110 comprend (figure 3-B) un démodulateur 110a et un démultiplexeur 110b.

A l'émission, l'amplificateur 12 distord les signaux OFDM en ce qui concerne à la fois leur amplitude et leur phase. Ces distorsions sont analysées sur la figure 2.

La courbe 1 représente, en abscisse l'amplitude du signal E, et en ordonnée (à droite) l'amplitude du signal R respectivement en entrée et en sortie de l'amplificateur 12 et (à gauche) le déphasage $\Delta \phi$ en radians. Les deux axes relatifs à l'amplitude sont gradués en valeurs d'amplitude normalisées par rapport à la valeur d'entrée $E_{sat}$ donnant un signal de sortie maximal. On observe qu'aux faibles valeurs de signal d'entrée E, le signal de sortie R lui est sensiblement proportionnel puis le signal de sortie R sature et passe par un maximum lorsque le signal d'entrée E croît. Cette saturation progressive provoque des distorsions.

De même on observe (courbe 2) qu'un déphasage $\Delta \phi$ est généré par l'amplificateur. Aux faibles valeurs du signal d'entrée E ce déphasage $\Delta \phi$ est nul ou très faible puis il croît vers une valeur de saturation lorsque le signal d'entrée E croît. Ces deux courbes sont caractéristiques d'un amplificateur comprenant un tube à ondes progressives mais des courbes analogues sont observées avec d'autres amplificateurs de puissance.

La figure 4 est un exemple de schéma de principe d'un multiplexeur OFDM 10a. Les données numériques représentant les symboles Sce codés à émettre, issues du codeur 9, subissent une transformation série-parallèle dans une unité 50. Considérons L symboles consécutifs transmis à la cadence $1/T_S$ à émettre sur L porteuses. L'unité 50 effectue une transformation série-parallèle et délivre en parallèle L symboles qui entrent dans une unité 52 qui effectue une transformée de Fourier inverse d'ordre N, tel que $N = 2^k > L$ avec $k$ entier. Pour cela, les L symboles sont complétés par un nombre $L1 = (N-L)/2$ de données "0" de part et d'autre en entrée de l'unité 52 (repère X). Si $N-L$ est impair, le début ou la fin du bloc reçoit un symbole de plus. Les N symboles (repère Y) qui sortent de l'unité 52 sont à leur tour complétés, dans une unité de protection 54, par $K_G$ symboles correspondant à un intervalle de garde $\Delta = K_G.T_S$ formant protection. Les $K_G$ symboles correspondent à une copie des derniers symboles des N symboles décrits précédemment. Ces $K_G$ symboles sont ajoutés devant les N symboles pour constituer un bloc de données de $(K_G + N)$ symboles à émettre (repère Z). Une unité 56 de transformation parallèle-série effectue la sérialisation des $(K_G + N)$ symboles. Les blocs successifs de $(K_G + N)$ symboles OFDM sont ensuite organisés en trame OFDM dans une unité 58 FRAME. Celle-ci ajoute des symboles spéciaux 53 (synchronisation, wobulation ou autres) qui servent, entre autres, à synchroniser l'émission et la réception ou à estimer le canal. Un filtre passebas 59 LPF filtre les signaux avant leur émission par le modulateur

A la réception les symboles Smr modulés reçus sont démodulés dans une unité de démodulation 110 (figure 3-B) qui comprend un démodulateur 110a et un démultiplexeur $OFDM^{-1}$ 110b qui effectue un traitement inverse de celui effectué à l'émission. Le démultiplexeur 110b comprend en série (figure 5) :

- un filtre passe-bas 69,
- un échantillonneur 63 à la cadence $1/T_S$,
- un dispositif 66 de transformation série-parallèle qui délivre N symboles utiles et qui donc ne tient pas compte des $K_G$ symboles reçus pendant l'intervalle de garde,
- un dispositif 62 de calcul d'une transformée de Fourier directe qui délivre une suite de blocs de N symboles.

Les extrémités des blocs de N symboles sont abandonnées pour ne conserver que la partie centrale comprenant L symboles.

- un dispositif 60 de transformation parallèle-série qui opère sur ces L symboles et qui délivre des symboles Scr codés reçus. Ces symboles Scr entrent dans le décodeur 109 (figure 1-B).

Si l'on voulait appliquer, au cas de la modulation à multiporteuses, la technique connue de prédistorsion à monoporteuse ceci nécessiterait de le faire sur chaque porteuse avant l'unité 52 du multiplexeur 10a. Cette méthode laisse apparaître en sortie du récepteur des distorsions dues' à des interférences interporteuses qu'il n'est pas possible de corriger.

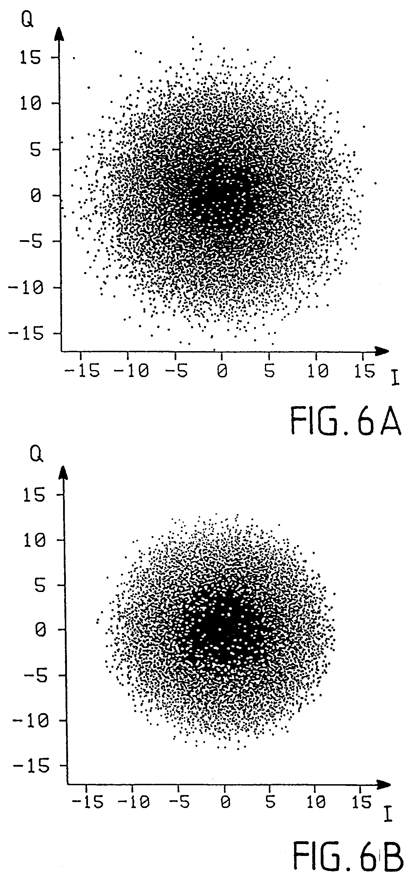

Lorsque l'on examine la distribution du signal OFDM dans le cas d'une modulation MAQ 16, on observe une distribution partie réelle I / partie imaginaire Q représentée sur la figure 6-A. C'est une distribution gaussienne avec une valeur moyenne nulle. Elle est symétrique autour de la valeur (0,0).

Le signal OFDM, à la sortie de l'amplificateur, a la distribution I/Q représentée sur la figure 6-B. Cette distribution n'est plus gaussienne car l'amplificateur est un dispositif non linéaire de sorte que l'amplitude en sortie de l'amplificateur est limitée à $E_{sat}/2$.

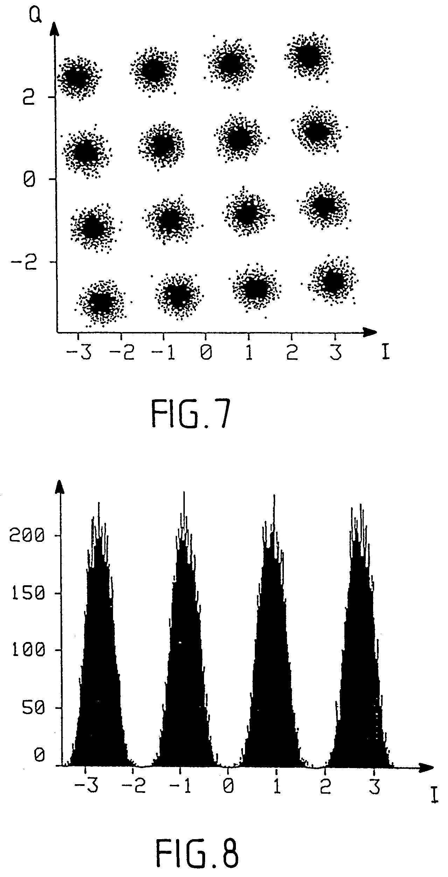

Lorsque l'on observe une constellation MAQ 16 telle qu'elle apparaît, à la réception, en sortie de l'unité de démodulation, on obtient le diagramme de la figure 7. Dans le cas d'un système à monoporteuse, une constellation MAQ 16 est constituée de taches plus ou moins oblongues selon leur position dans la constellation. Contrairement à ceci, dans le cas d'un système à multiporteuses, on observe que :

- les nuages de points reçus ont une forme circulaire, compacte au centre de chaque nuage. Chaque nuage a une distribution quasiment gaussienne,
- ces nuages ont un même étalement quel que soit le symbole transmis. Ainsi tous les symboles sont également affectés,
- tous les nuages de points sont soumis à une rotation identique et à un facteur d'échelle identique,
- la constellation conserve sensiblement une forme carrée. Tout se passe comme si la grille carrée formant la constellation avait subi une rotation d'ensemble autour de l'origine.

L'équidistribution des points dans chaque nuage apparaît clairement sur l'histogramme de la partie réelle du signal reçu représenté sur la figure 8 pour une constellation MAQ 16. Les quatre distributions en forme de cloche indiquent la distribution symétrique de points. Ces distributions non centrées autour des valeurs -3, -1, 1, 3 soulignent la rotation de la constellation.

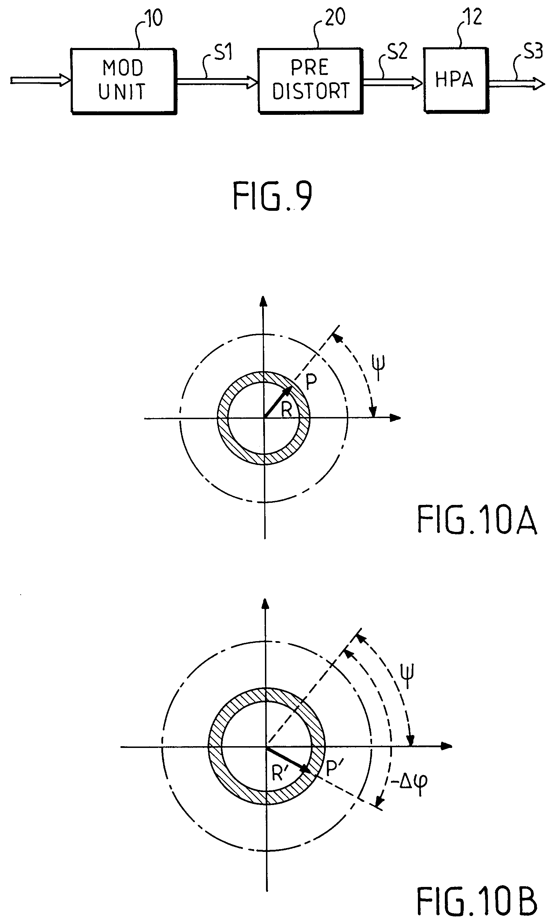

Pour corriger, selon l'invention, les distorsions apportées par l'amplificateur à la modulation OFDM, on dispose un circuit de prédistorsion 20 entre la sortie du modulateur OFDM 10 et l'entrée de l'amplificateur 12 (figure 9). Le circuit de prédistorsion agit sur le signal OFDM en effectuant une prédistorsion qui tient compte de l' amplitude dudit signal. De la sorte, le modulateur OFDM délivre un premier signal OFDM S1 qui entre dans le circuit de prédistorsion. Celui-ci délivre un second signal OFDM S2 prédistordu de telle manière qu'après le passage du signal OFDM prédistordu dans l' amplificateur celui-ci délivre un troisième signal OFDM S3 non distordu. Cette non distorsion reste limitée à la dynamique de l'amplificateur.

Pour effectuer la prédistorsion, la distribution (figure 6-A) du premier signal OFDM est, selon l'invention, décomposée en une série d'anneaux consécutifs. La figure 10-A représente un des anneaux. Le cercle en traits interrompus représente l'amplitude maximale du signal. A un point P de l'anneau ayant pour amplitude R et pour phase $\psi$, on fait correspondre (figure 10-B) un point P' ayant une amplitude R' et un déphasage additionnel -$\Delta \phi$. Les valeurs de R' et de -$\Delta \phi$ en fonction de R sont déterminées d'après les caractéristiques de l'amplificateur concerné. La prédistorsion consiste alors à remplacer un point P de caractéristiques (R, $\psi$) par un point P' de caractéristiques (R', $\psi$ - $\Delta \phi$).

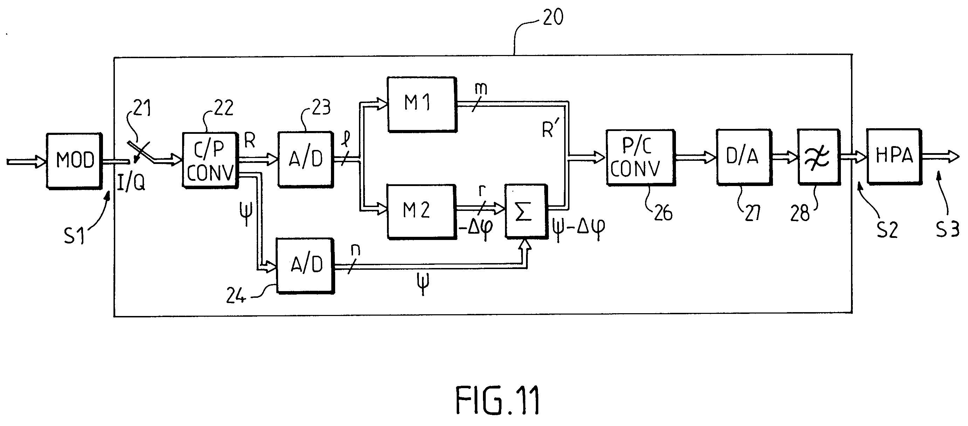

La figure 11 représente un schéma d'un circuit de prédistorsion pour effectuer la transformation précédente. Habituellement le modulateur MOD délivre des signaux modulés ayant une composante en phase I et une composante en quadrature Q qui forment le signal OFDM S1. Ce signal complexe est échantillonné par un échantillonneur 21 à une cadence multiple de la cadence du signal S1, par exemple 8/Ts lorsque Ts est la durée d'un symbole OFDM. Un convertisseur 22 effectue une conversion des coordonnées cartésiennes I/Q en coordonnées polaires R, $\psi$. Il est également possible d'utiliser un modulateur qui délivre directement le signal OFDM S1 selon les coordonnées polaires R, $\psi$ auquel cas le convertisseur 22 n'existe pas.

Le convertisseur 22 délivre une composante radiale R échantillonnée et une composante en phase $\psi$ échantillonnée. La composante radiale R est quantifiée sur l bit par un quantifieur 23. Ces l bits servent à adresser deux mémoires, l'une M1 qui fournit la composante radiale prédistordue R' correspondant à la composante radiale R et l'autre M2 qui fournit la correction de phase -$\Delta \phi$ correspondant à la composante radiale R.

Ces deux mémoires sont chargées préalablement par des tables qui sont établies d'après les caractéristiques de l'amplificateur placé en aval, ces tables étant, par exemple, déterminées à l'aide de la figure 2. Les mémoires M1 et M2 fournissent des résultats quantifiés respectivement sur m bits et r bits.

La composante de phase $\psi$ est également quantifiée sur n bits par un quantifieur (24). Afin de déterminer la phase réelle du point P' (figure 10-B), il faut additionner la phase $\psi$ du point P à l'écart de phase -$\Delta \phi$ donné par la prédistorsion. Ceci est opéré dans un sommateur $\Sigma$.

Les composantes radiales prédistordues R' et en phase ($\psi$ - $\Delta \phi$) sont transformées en signaux I/Q dans un convertisseur 26 qui effectue une conversion inverse de celle effectuée par le convertisseur 22. Le signal complexe obtenu est transformé en analogique dans un convertisseur numérique-analogique 27 puis filtré par un filtre passe-bas 28 pour délivrer le signal OFDM prédistordu S2. Lorsque ce signal S2 a été amplifié par l'amplificateur, on obtient le signal OFDM S3 non distordu.

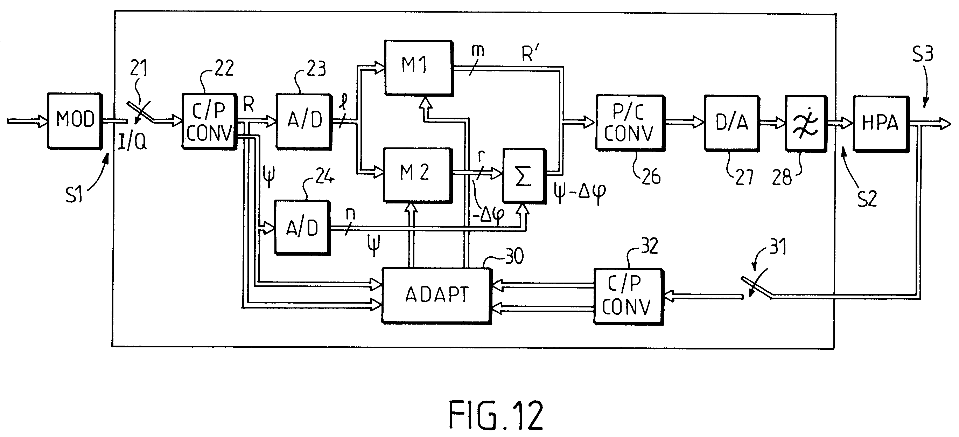

Le schéma de la figure 11 correspond à un circuit de prédistorsion fixe. Il est possible de tenir compte des variations au cours du temps ou avec la température, des caractéristiques notamment de l'amplificateur. Pour cela la figure 12 représente un schéma d'un circuit de prédistorsion adaptative. Les mêmes éléments que ceux de la figure 11 sont indiqués avec les mêmes repères. La modification dans ce cas consiste à comparer le signal obtenu en sortie de l'amplificateur avec le signal fourni en entrée, à déterminer des écarts et à modifier en conséquence le contenu des tables stockées dans les mémoires M1 et M2.

Pour cela, un circuit d'adaptation 30 reçoit le signal S1 (après échantillonnage 21 et conversion 22) et le signal S3 (après échantillonnage et conversion). Un échantillonneur 31 et un convertisseur cartésien/polaire 32 effectuent respectivement l'échantillonnage et la conversion du signal S3. Le circuit d'adaptation 30 détermine des écarts (S1 - S3) et adapte les valeurs stockées dans M1 et M2 pour réduire ces écarts, par exemple, par une méthode de réduction du gradient de l'erreur.

On a observé expérimentalement qu'une quantification sur l = 8 bits, soit une décomposition de la distribution de la figure 6-A en 256 anneaux, a donné des résultats satisfaisants. Les composantes radiales R' délivrées par M1 étaient codées sur m = 8 bits et les composantes de phase $\Delta \phi$ délivrées par M2 étaient codées sur r = 5 bits. Les mémoires M1 et M2 ont ainsi à stocker 256 mots de respectivement 8 bits et 5 bits. Elles sont donc de petite taille.

Au démarrage du circuit de prédistorsion adaptive, il est possible d'initialiser les tables des mémoires par des valeurs $\Delta \phi$ = 0 pour M2 et des valeurs R' = R pour M1 et de faire opérer le circuit d'adaptation plusieurs fois consécutivement pour qu'il détermine les valeurs des tables à stocker dans M1 et M2. Après cette étape de convergence, la mise à jour des tables n'a à être réalisée que de temps à autre.

## Revendications

1. Système de transmission de signaux numériques opérant par codage d'une constellation, le système comprenant une unité (10) de modulation à multiporteuses qui génère des signaux à multiporteuses (S1) et un amplificateur (12) qui provoque des distorsions de signaux, caractérisé en ce qu'il comprend un circuit de prédistorsion (20) placé entre l'unité de modulation à multiporteuses et l'amplificateur, ledit circuit prédistordant les signaux à multiporteuses (S1), reçus en entrée, dans un sens opposé aux distorsions créées par l'amplificateur et générant des signaux prédistordus (S2) à multiporteuses tels qu'après leur passage dans l'amplificateur celui-ci délivre des signaux (S3) non distordus à multiporteuses.

2. Système selon la revendication 1 caractérisé en ce que le circuit de prédistorsion prédistord l'amplitude et la phase des signaux à multiporteuses d'entrée (S1) en fonction de leur amplitude radiale.

3. Système selon la revendication 1 caractérisé en ce que le circuit de prédistorsion comprend :
   - des moyens pour échantillonner (21) et quantifier (23) les signaux d'entrée (S1),
   - des moyens pour prédistordre (M1, M2) des valeurs d'amplitude polaire et de phase des signaux d'entrée (S1),
   - des moyens (27) (28) pour générer des composantes en phase et en quadrature des signaux prédistordus (S2).

4. Système selon la revendication 3 caractérisé en ce que le circuit de prédistorsion comprend en entrée une unité (22) de conversion cartésienne/polaire pour convertir les signaux d'entrée (S1) échantillonnés.

5. Système selon une des revendications 1 à 4 caractérisé en ce que le circuit de prédistorsion (20) comprend un circuit d'adaptation (30) qui calcule des écarts entre les signaux d'entrée (S1) et les signaux (S3) de sortie de l'amplificateur et qui adapte les moyens de prédistorsion (M1, M2) pour réduire ces écarts.

FIG.1A

FIG.1B

FIG.2

FIG.3 A

FIG.3 B

FIG.4

FIG.5

FIG.6A

FIG.6B

FIG.7

FIG.8

FIG.9

FIG.10A

FIG.10B

FIG.11

EP 0 632 624 A1

FIG.12

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | EP-A-0 378 719 (SIEMENS AKTIENGESELLSCHAFT) <br> * abrégé; revendications 1,2,4,7; figures * <br> * colonne 1, ligne 16 - colonne 3, ligne 22 * | 1-5 | H04L27/36 <br> H03F1/32 <br> H04L5/06 |
| A | PROCEEDINGS OF THE 2ND EUROPEAN CONFERENCE ON SATELLITE COMMUNICATIONS ECSC-2, LIÈGE, BE, 22.-24.10.1991, ESA NORDWIJK, NL pages 179 - 184, XP400752 <br> C. RAPP: 'Effects of HPA-Nonlinearity on a 4-DPSK/OFDM-Signal for a Digital Sound Broadcasting System.' <br> * abrégé * <br> * page 179, colonne de gauche, ligne 1 - page 180, colonne de droite, ligne 3 * <br> * page 184, colonne de gauche, ligne 6 * | 1-5 | |
| D,A | BELL SYSTEM TECHNICAL JOURNAL, vol.62, no.4, Avril 1983, NEW YORK US pages 1019 - 1033 <br> A.A.M. SALEH / J. SALZ: 'Adaptive Linearization of Power Amplifiers in Digital Radio Systems.' <br> * page 1021, alinéa II - page 1023, alinéa III; figures 1,2,4 * | 1-5 | **DOMAINES TECHNIQUES RECHERCHES (Int.Cl.6)** <br><br> H04L <br> H03F |
| D,A | EBU REVIEW- TECHNICAL, no.224, Août 1987, BRUSSELS BE pages 168 - 190 <br> M. ALARD / R. LASALLE: 'Principles of modulation and channel coding for digital broadcasting for mobile receivers.' <br> * page 169, colonne de droite, alinéa 2.1 - page 170, colonne de droite, alinéa 2.3 * | 1-5 | |

Le présent rapport a été établi pour toutes les revendications

| Lieu de la recherche | Date d'achèvement de la recherche | Examinateur |
|---|---|---|
| LA HAYE | 28 Septembre 1994 | Gries, T |